# EUROPÄISCHE PATENTSCHRIFT

(11) **EP 0 278 073 B1**
(45) Veröffentlichungstag und Bekanntmachung des Hinweises auf die Patenterteilung: **23.06.1993**
(21) Anmeldenummer: 87116978.5
(22) Anmeldetag: 17.11.1987
(51) Int. Cl.: G01R 1/073

(54) **Prüfstift für einen Adapter eines Leiterplattenprüfgerätes**
Probe for an adapter for a device for testing printed circuit boards
Sonde pour un adaptateur pour un dispositif d'essai de cartes imprimées

(30) Priorität: 18.11.1986 DE 3639360
(43) Veröffentlichungstag der Anmeldung: 17.08.1988
(73) Patentinhaber: Luther & Maelzer GmbH, D-31515 Wunstorf (DE)
(72) Erfinder: Maelzer, Martin, D-3050 Wunstorf (DE); Dehmel, Rüdiger, D-3050 Wunstorf (DE); Higgen, Hans-Hermann, D-3060 Stadthagen (DE); Gülzow, Andreas, D-3257 Springe 6 (DE)
(74) Vertreter: Schmidt-Evers, Jürgen, Dipl.-Ing.

(56) Entgegenhaltungen:
- DE-A- 3 444 708
- DE-A- 3 533 218
- VA-KATALOG, Februar 1985, Seiten 29-33, Konstanz; "Ingun Prüfmittelbau"

## Beschreibung

Die Erfindung bezieht sich auf einen Prüfstift nach dem Oberbegriff des Anspruchs 1.

Zwecks elektrischer Verbindung im Raster befindlicher Prüfkontakte eines Leiterplattenprüfgerätes mit in und/oder außer Raster befindlichen Prüfpunkten eines Prüflings wird ein Adapter mit Prüfstiften in einer der Anzahl der Prüfkontakte bzw. Prüfpunkte entsprechenden Anzahl bestückt, wobei die Prüfstifte zwecks Verbindung der Prüfkontakte und Prüfpunkte in unterschiedlichen Schrägstellungen in den Adapter eingesetzt werden und mit ihren Enden Kontaktstellen für die Prüfkontakte bzw. Prüfpunkte bilden. Die Bestückung des Adapters mit den Prüfstiften kann sowohl manuell als auch maschinell und dabei halb- oder vollautomatisch erfolgen.

Im VA-Katalog, Feb. 1985, Seiten 29 bis 33 der Firma INGUN-Prüfmittelbau GmbH & Co.KG, Konstanz ist auf Seite 29 ein mit der Nummer 11 versehener Prüfstift für einen Adapter zeichnerisch dargestellt, dessen Führungsabschnitt sich gegen den Kontaktionsabschnitt hin im Querschnitt konisch verringert. Außerdem sind auf der der Seite 32 ff. (nicht numerierten Seite) dieses Katalogs jeweils einen Kopf aufweisende Prüfstifte dargestellt, die in einen Adapter eingesetzt sind, wobei die Köpfe einen Abstand von der obersten Platte des Adapters aufweisen.

In der im Dokument DE-A-3 444 408 beschriebenen Ausgestaltung eines Prüfstifts weist dieser einen zylindrischen Schaft als Führungsabschnitt auf, der stirnseitig kegelförmig angespitzt ist, wobei der Spitzenwinkel etwa 90° beträgt. Die stirnseitige Anspitzung bildet den Kontaktabschnitt des Prüfstiftes.

Die Ausbildung einer solchen verhältnismäßig stumpfen Spitze am Prüfstift hat folgenden Zweck. Bei der eingangs beschriebenen Ausgestaltung ist der Prüfstift in Führungslochabschnitten einsteckbar, die sich in übereinander angeordneten Führungsplatten des Adapters erstrecken. Zwecks zwangsläufigen Einführens der Spitze des Prüfstiftes in das jeweilig nächste Führungsloch in den Führungsplatten sind die Führungslöcher von Führungsplatte zu Führungsplatte so zueinander versetzt, daß der Prüfstift mit seiner Spitze innerhalb des Lochrandes des jeweils nächsten Führungslochs auf letzteres auftrifft. Der Prüfstift wird somit bei jedem Auftreffen auf den Lochrand in das zugehörige Führungsloch und somit in die richtige Position gelenkt.

Diese bekannte Ausgestaltung hat sich als sehr vorteilhaft erwiesen, jedoch ist sie aus folgenden Gründen noch verbesserungsbedürftig. Aufgrund der vorgegebenen Dicke der Prüfstifte können nur solche Prüflinge geprüft werden, deren Prüfpunkte einen verhältnismäßig großen Abstand voneinander haben. Hierdurch sind die Einsatzmöglichkeiten dieses Adapters beschränkt, und zwar auch für sog. SMD-Prüflinge (SMD = surface mounted devices).

Der Erfindung liegt die Aufgabe zugrunde, einen Prüfstift der eingangs bezeichneten Art so auszugestalten, daß auch Prüflinge mit einem verhältnismäßig geringen Abstand ihrer Prüfpunkte voneinander bzw. mit großen Prüfpunkt-Versetzungen außer Raster geprüft werden können.

Diese Aufgabe wird durch das Kennzeichen des neuen Anspruchs 1 gelöst.

Bei der erfindungsgemäßen Ausgestaltung können der oder die Prüfstifte so weit schräggestellt werden, daß ihre Spitze jeweils dicht am benachbarten Prüfstift liegt. Anders ausgedrückt ist der Prüfstift so angespitzt, daß seine Spitze bei maximal möglicher Schrägstellung des Prüfstiftes - gesehen in einer Projektion senkrecht zum Adapter - einen Außenpunkt bildet bzw. auf dem Umfang seines Projektionsbildes liegt. Bei der erfindungsgemäßen Ausgestaltung läßt sich der Abstand zwischen den Prüfpunkten ganz erheblich verringern. In diesem Zusammenhang ist zu bemerken, daß der Abstand der Prüfpunkte auch von der aus Festigkeitsgründen erforderlichen Wanddicke zwischen zwei benachbarten Führungslöchern des Adapters abhängig ist. Infolgedessen sind im Rahmen der Erfindung auch solche Ausgestaltungen möglich, bei denen die Spitze des Prüfstiftes sich in einem solchen Abstand innerhalb des Randes des Projektionsbildes befindet, der etwas geringer ist als die halbe Wandstärke zwischen den benachbarten Führungslöchern.

Die gestufte Ausgestaltung ist aus herstellungstechnischen Gründen vorteilhaft, weil sich ein solcher Prüfstift durch Hämmern herstellen läßt. Aufgrund des jeweiligen kegelförmigen Übergangs von Stufe zu Stufe ist eine störungsfreie Einführung der Prüfstifte in die Führungslöcher gewährleistet.

Die in den Ansprüchen 2 und 3 enthaltene Länge der Konvergenz bestimmt sich nach der maximalen Schrägstellung des Prüfstiftes.

Die im Anspruch 4 enthaltenen Merkmale vereinfachen die Führung des Prüfstiftes.

Die Ausbildung nach Anspruch 5 trägt dazu bei, die Prüfstifte im Bereich ihrer Spitze zu stabilisieren. Es kann sich bei dieser Maßnahme sowohl um eine progressive Verjüngung handeln als auch um eine kegelförmige Anspitzung mit einem gegenüber der übrigen Verjüngung größeren Kegelwinkel. Es ist auch vorteilhaft, die Spitze der Prüfstifte zu runden oder geringfügig zu stumpfen, was ebenfalls eine progressive Verjüngung darstellt.

Aufgrund der erfindungsgemäßen Verjüngung ist der Prüfstift insbesondere im Bereich nahe seiner Spitze biegsam. Eine gewisse Biegsamkeit kann einerseits als vorteilhaft angesehen werden, jedoch soll andererseits zumindest eine wesentliche Verbiegung der Prüfstifte vermieden werden. Hierzu tragen die Merkmale des Anspruchs 7 bei.

Nachfolgend wird die Erfindung anhand von in vereinfachten Zeichnungen dargestellten Ausführungsbeispielen näher erläutert. Es zeigt
- Fig. 1: einen Teilschnitt durch ein Gerät zum Prüfen von Leiterplatten, wobei der Teilschnitt senkrecht zum im Gerät aufgenommenen, mit Prüfstiften bestückten Adapter verläuft;
- Fig. 2: den Adapter im vertikalen Querschnitt;
- Fig. 3: den Schnitt III-III in Fig. 2;
- Fig. 4: einen Prüfstift gemäß der Erfindung;
- Fig. 5: eine Prüfstiftspitze in vergrößerter Darstellung;
- Fig. 6: schematisch einen Prüfstift mit seinem Projektionsbild;
- Fig. 7 und 8: unterschiedliche Positionen bzw. Schrägstellungen für Prüfstifte im Adapter;
- Fig. 9 und 10: Einzelheiten der Führung der Prüfstifte in vergrößerter Darstellung.

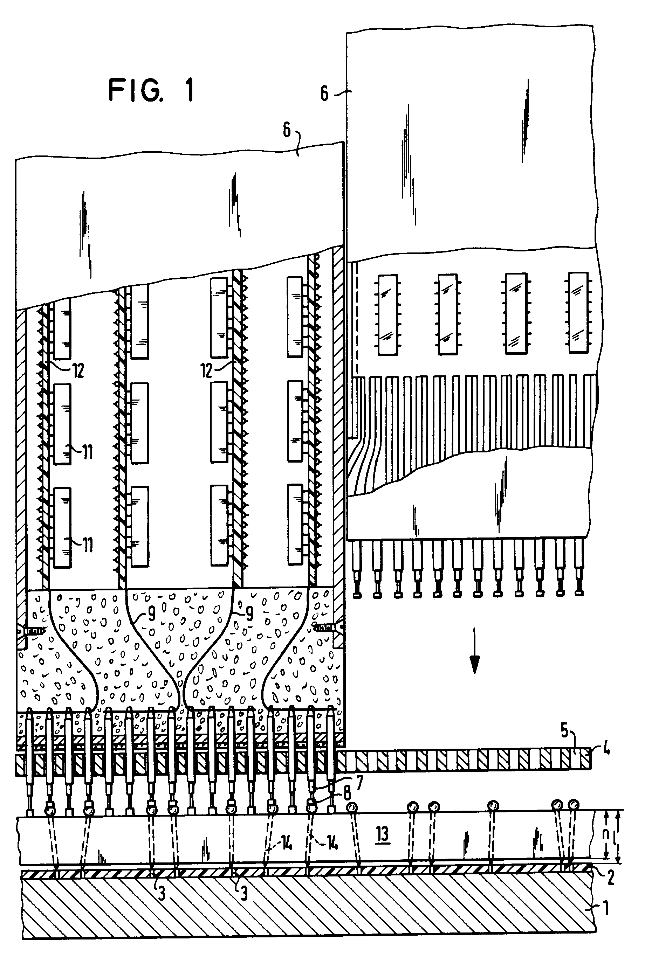

In der Fig. 1 ist eine Aufnahmeplatte des im ganzen nicht dargestellten Gerätes zum Prüfen von Leiterplatten mit 1 bezeichnet. Auf dieser Aufnahmeplatte 1 befindet sich eine Leiterplatte 2 mit Prüfpunkten 3. Oberhalb der zu prüfenden Leiterplatte 2 befinden sich eine Rasterlochplatte 4, deren Löcher 5 im Raster angeordnet sind, und zwei in Richtung auf die Leiterplatte 2 und zurück bewegliche Moduln 6, die an ihren unteren Stirnseiten mit Prüfkontakten 7 in Form von Stiften versehen sind, welche in der herabgefahrenen Position eines Moduls 6 die Löcher 5 in der Rasterlochplatte 4 durchgreifen. Die Prüfkontakte 7 tragen teleskopisch ein- und ausfahrbare Prüfkontaktköpfe 8, die in Richtung auf ihre äußere Endstellung durch eine nicht dargestellte Feder vorgespannt sind.

Die Prüfkontakte 7 sind in den Moduln 6 durch Vergießen befestigt und stehen durch elektrische Leitungen 9 mit IC-Chips 11 tragenden Leiterplatten 12 in Verbindung, die innerhalb der Moduln 6 angeorndet sind und in ihrer Gesamtheit mit den Leiterplatten 12, den IC-Chips 11 und ggf. weiteren Bauelementen eine den Prüfkontakten 7 zugeordnete Teilschalter-Matrix bilden.

Auf der Leiterplatte 2 befindet sich ein Rasteranpassungs-Adapter 13, der eine Vielzahl ihn durchfassender, schematisch dargestellter Prüfstifte 14 aufweist, die die im Raster angeordneten Prüfkontakte 7 mit den in und/oder außer Raster angeordneten Prüfpunkten 3 verbinden. Betreffende Prüfstifte 14 liegen deshalb nicht in der jeweiligen Flucht mit den Prüfkontakten, sondern erstrecken sich schräg durch den Adapter 13, wobei sie an ihren oberen Enden mit Köpfen und an ihren unteren Enden mit Überlänge aus dem Adapter 13 hervorragen und gegenüber der Ober- und Unterseite erhabene Kontaktstellen bilden.

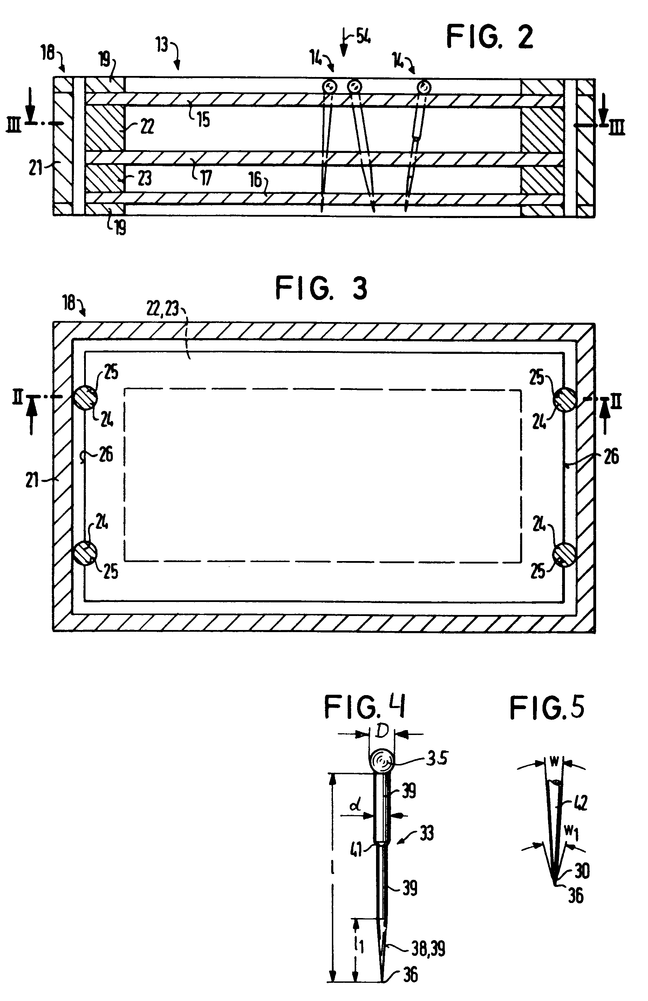

Der Adapter 13 weist mehrere übereinander angeordnete und einen Abstand zwischen sich aufweisenden Führungsplatten auf. Beim Ausführungsbeispiel gemäß Fig. 2 sind drei Führungsplatten vorhanden, von denen die oberste mit 15, die unterste mit 16 und die mittlere 17 bezeichnet ist. Es sind andeutungsweise drei Prüfstifte 14 dargestellt, die im einzelnen noch beschrieben werden. Der Adapter 13 weist einen allgemein mit 18 bezeichneten Rahmen auf, der aus Rahmenteilen 19, 21 bestehen kann, in dem die Führungsplatten 15 bis 17 mit zwischen diesen angeordneten Distanzleisten 22, 23 positioniert sind. Die Distanzleisten 22, 23 bilden jeweils ebenfalls einen Rahmen (vgl. Fig. 3) wodurch die Führungsplatten 15, 17 an ihrem ganzen Umfang abgestützt und somit erheblich stabilisiert sind.

Wie aus Fig. 3 deutlich zu erkennen ist, dienen zur horizontalen Positionierung der Führungsplatten 15 bis 17 im Rahmen 18 senkrecht angeordnete Haltebolzen 24 vorzugsweise runden Querschnitts, die auf verschiedene Weise im Rahmen 18, insbesondere in den oberen und unteren Rahmenteilen 19 fixiert sein können, z.B. in Löchern stecken, wobei Madenschrauben zur Axialfixierung dienen können. Es sind beim vorliegenden Ausführungsbeispiel vier Haltebolzen 24 vorgesehen, die aneinander gegenüberliegenden Seiten in einem Abstand voneinander angeordnet sind. Die Haltebolzen 24 greifen schließend in ihrem Querschnitt entsprechende etwa halbrunde Quernuten 25 ein, die sich an entsprechend gegenüberliegenden Rändern der Führungsplatten 15 bis 17 befinden. Diese Ausgestaltung ermöglicht bei einer sicheren Positionierung eine leichte Montage bzw. Demontage der Führungsplatten 15 bis 17, da diese nicht parallel eingeschoben werden müssen, sondern um einen der mit 26 bezeichneten Ränder ein- bzw. ausgeschwenkt werden können. Zwischen dem Rahmen 18 und dem Umfang der Führungsplatten 15 bis 17 bzw. deren Ränder 26 besteht ein Abstand, der ein Ergreifen der Führungsplatten ggf. mittels eines Werkzeugs ermöglicht. Eine vorteilhafte Herstellungsart der Quernuten 25 besteht darin, diese zunächst als Bohrungen in genau festgelegten Positionen in Führungsplatten 15 bis 17 größerer Abmessung einzubringen, z.B. durch Stanzen oder Bohren, und anschließend die betreffenden Ränder z.B. durch Fräsen soweit zu kürzen, daß sich etwa halbrunde Quernuten 25 ergeben.

Der in Fig. 4 mit 33 bezeichnete Prüfstift besteht aus einem im Querschnitt runden Schaft 34, der an einem Ende einen kugelförmigen Kopf 35 aufweist und an seinem anderen Ende angespitzt ist. Die Spitze ist mit 36 bezeichnet. Eine die Anspitzung bildende Verjüngung ist mit 38 bezeichnet, und sie erstreckt über einen Teil der Schaftlänge l, dessen Länge l₁ sich ergibt, wenn man sich vorstellt, daß die Mantelfäche der Verjüngung innerhalb einer zylindrischen Einhüllenden liegen soll, die senkrecht zu den Führungsplatten steht. Der Prüfstift 33 gemäß Fig. 4 ist stufenförmig zur Spitze 36 hin verjüngt, wobei die mit 39 bezeichneten Stufen zylindrisch sind. Die Übergänge 41 von Stufe zu Stufe sind kegelförmig abgeschrägt. An die in Fig. 4 unterste Stufe 39 schließt sich die kegelförmige Verjüngung 38 an, deren Länge l₁ sich wie vorbeschrieben ergibt.

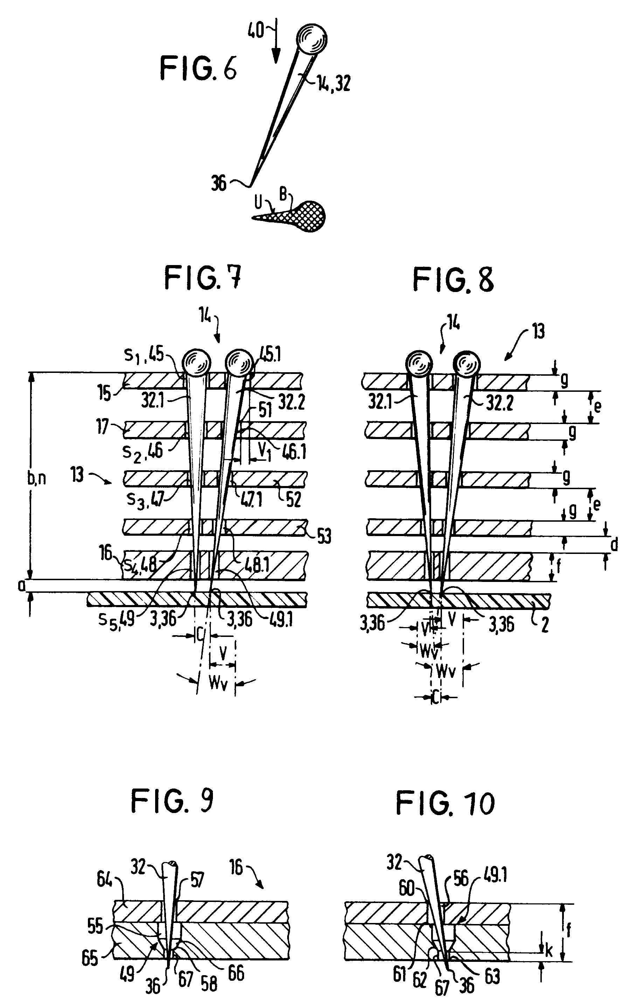

Zwecks Verstärkung der Spitze 36 ist es vorteilhaft, diese durch eine geringe Abstumpfung 30 zu bilden, was durch eine progressive Verjüngung, eine Rundung, eine geringe Abflachung oder auch durch eine kegelförmige Anspitzung eines gegenüber dem Winkel w der allgemein mit 42 bezeichneten Hauptverjüngung größeren Kegelwinkels w₁ gebildet sein kann. Eine so geformte Spitze 36 ist in Fig. 5 in vergrößerter Darstellung beispielhaft dargestellt.

Es kann sich die Anzahl der Stufen 39 nach der Anzahl der vorhandenen Führungsplatten richten, d.h. zumindest im oberen Bereich des Adapters 13 kann jeder Führungsplatte eine Stufe zugeordnet sein.

Bei den vorliegenden Ausführungsbeispielen beträgt der größte Schaftdurchmesser d 1,3 bis 1,4 mm im Durchmesser, während der Durchmesser D des Kopfes 35 etwa 2 mm beträgt.

Fig. 6 zeigt schematisch einen Prüfstift 32 in max. Schrägstellung und in der Seitenansicht sowie sein Projektionsbild B in der Projektion von oben, d.h, senkrecht zu den Führungsplatten bzw. längs des Pfeiles 40. Es ist deutlich erkennbar, daß die Spitzen sich im Projektionsbild B an dessen Umfang U befindet.

Die Prüfstift-Anordnungen gemäß den Fig. 7 und 8 stellen zwei prinzipielle maximale Schrägstellung für Prüfstifte 14 dar, in denen diese die Prüfkontaktköpfe 8 mit den Prüfpunkten 3 der Leiterplatte 2 verbinden. Bei dem Beispiel gemäß Fig. 7, bei dem Prüfstifte 32 gemäß Fig. 6 verwendet werden, befinden sich der Prüfstift 32.1 bzw. die ihn aufnehmenden, zylindrischen Führungslöcher 45 bis 49 in einer zu den Führungsplatten senkrechten Position, d.h., es ist zwischen den Führungslöchern 45 bis 49 kein seitlicher Versatz vorhanden bzw. die Führungslöcher 45 bis 49 befinden sich im Raster. Dagegen befindet sich der mit 32.2 bezeichnete Prüfstift in einer maximalen Schrägstellung, in der seine Spitze 36 gegenüber dem zugehörigen Kopf 35 bzw. zugehörigen Führungsloch 45.1 um das Versatzmaß V zum Prüfstift 32.1 hin versetzt ist. Die Führungslöcher 46.1 bis 49.1 befinden sich somit außer Raster. Die zwischen den Führungslöchern 49 und 49.1 vorhandene Wandstärke bemißt sich zum einen nach einer erforderlichen Festigkeit und zum anderen nach dem Versatzwinkel wᵥ sowie dem Abstand a der Spitze 36 von der untersten Führungsplatte 16, der etwa 0,6 mm beträgt und den Kontaktionsabschnitt des Prüfstiftes darstellt. Der übrige Abschnitt b des Schaftes 34 des Prüfstiftes ist der Führungsabschnitt, auf dem der Prüfstift radial positioniert ist. Der Führungsabschnitt b entspricht der Höhe n des Adapters 13. Aufgrund der erfindungsgemäßen Ausgestaltung lassen sich Abstände c zwischen den Spitzen 36 erreichen, die etwa 0,6 mm betragen. Insbesondere für SMD-Prüflinge werden solche geringen Abstände c angestrebt.

Der Versatz v₁ zwischen dem Führungsloch 45.1 in der Führungsplatte 15 und dem Führungsloch 46.1 in der Führungsplatte 16 ist so groß bemessen, daß bei senkrechter Einführung des Prüfstiftes 32.2 dessen Spitze 36 in einer Position geringfügig innerhalb des Lochrandes 51 des Führungslochs 46.1 auf letzteres trifft, so daß der Führungsstift 32.2 zwangsläufig in das Führungsloch 46.1 eingezogen und dabei schräg gestellt wird. Die Führungslöcher 47.1 und 48.1 in den bei den Ausführungsbeispielen gemäß Fig. 7 und 8 vorhandenen zwei weiteren Führungsplatten 52, 53 zwischen der Führungsplatte 17 und der untersten Führungsplatte 16 können entsprechend versetzt sein, um beim Vorhandensein einer geringfügig gestumpften Spitze 36 (s. Fig. 5) oder beim Vorhandensein einer Verjüngung 38 gemäß Fig. 4 einen entsprechenden Einzugseffekt in die jeweilige Führungsbohrung zu erreichen.

Die jeweils einer Führungsplatte 15 bis 17, 52, 53 zugehörigen Führungslöcher 45 bis 49, 45.1 bis 49.1 sind vorzugsweise im Durchmesser jeweils gleich. Dagegen sind die Durchmesser der Führungslöcher im den Führungsplatten 15 bis 17, 52, 53 von Führungsplatte zu Führungsplatte an den sich verjüngenden Prüfstiftquerschnitt anzupassen. Die Durchmesser der Führungslöcher 45 bis 49 bzw. 45.1 bis 49.1 verringern sich somit zur Spitze 36 der Prüfstifte 14 hin.

Das Führungsspiel s₁ bis s₅ in den Führungslöchern nimmt in Einsteckrichtung 54 der Prüfstifte 14 ab. Zwecks genauer Führung ist für das unterste Führungsloch 49 bzw. 49.1 ein Spiel s₅ von nur 0,1 bis 0,2 mm vorgesehen.

Aufgrund der vorbeschriebenen Anordnung wird eine reproduzierbare Positionierung der Prüfstifte in den durch die Führungslöcher vorbestimmten Positionen in den Führungsplatten erreicht.

Den Führungsplatten 52, 53 kommt im wesentlichen eine seitliche Stützfunktion zu, da die Prüfstifte 14 bzw. 33 in diesem Bereich aufgrund der Querschnitts-Verjüngung 38 recht dünn und deshalb biegsam sind. Die Stützfunktion wird insbesondere dann wirksam, wenn im Betrieb die Prüfstifte 14 zwecks Kontaktierung der Prüfpunkte 3 und der Prüfkontaktköpfe 8 axial unter Druck gesetzt werden. Für den gleichen Zweck ist der Abstand d zwischen der untersten Führungsplatte 16 und der darüber befindlichen Führungsplatte 53 geringer bemessen als der Abstand e zwischen den übrigen Führungsplatten, wobei die übrigen Abstände e vorzugsweise gleich sind.

Beim Ausführungsbeispiel gemäß Fig. 8 kommen ebenfalls Prüfstifte 32 zum Einsatz, wobei der Versatz V bzw. Versatzwinkel wᵥ geringer ist als beim vorbeschriebenen Ausführungsbeispiel und zwar dadurch, daß beide Prüfstifte 32.1, 32.2 mit ihren Spitzen 36 um den gleichen Versatz V aufeinanderzu versetzt sind bzw. schräg stehen.

Aus den Fig. 7 und 8 ist deutlich erkennbar, daß aufgrund der Verjüngung der Prüfstifte 14 der Abstand c zwischen den Spitzen 36 zweier benachbarter Prüfstifte 14, von denen wenigstens einer schräg steht, erheblich verringert werden kann. Beim vorliegenden Ausführungsbeispiel beträgt der geringste Abstand c 0,6 mm. D.h., es können auch Prüflinge (Leiterplatten) mit einem geringen Abstand zwischen Prüfpunkten 3 geprüft werden.

Weitere Maßnahmen zur verbesserten seitlichen Abstützung der Prüfstifte 14 bzw. 33 sind aus den Fig. 9 und 10 ersichtlich. Eine Maßnahme besteht darin, die unterste Führungsplatte 16 dicker (Maß f) zu bemessen, als die Dicke g der übrigen Führungsplatten 15, 17, 52, 53, die gleich dick bemessen sein können. Je größer die Dicke f ist, desto größer sind auch die Stützabschnitte, die insbesondere dann wirksam ausgenutzt werden können, wenn die Führungslöcher 49, 49.1 an die Verjüngung 38 der Prüfstifte 14 angepaßt konisch verlaufen (nicht dargestellt) oder in Stufen angeordnet sind. Diese Stufen können erreicht werden, durch eine einerseits etwa mittige Locherweiterung 55 im Führungsloch 49, 49.1 und/oder wenigstens einen versetzten Lochabschnitt 56, wodurch bei entsprechender Anpassung der jeweiligen Lochdurchmesser an den jeweilig vorhandenen Querschnitt der Vejüngung 38 sich seitlich stützend wirksame Lochränder 57, 58 (Fig. 9) und 60 bis 63 (Fig. 10) ergeben. Zwecks leichterer Verwirklichung sowohl der Locherweiterung 55 als auch des versetzen Lochabschnitts 56 ist es vorteilhaft, die unterste Führungsplatte 16 aus zwei Plattenteilen 64, 65 zu bilden. Es ist auch noch hervorzuheben, daß der Abstand k der Locherweiterung 55 von der Unterseite der untersten Führungsplatte 16 gering, vorzugsweise etwa 1 mm, gehalten werden soll, um bei etwa senkrechter Anordnung des Prüfstiftes 14 einen möglichst nahe an der Spitze 36 gelegenen Abstützungspunkt (Lochrand 58) zu erhalten (Fig. 9). Die Locherweiterungen 55 gehen unterseitig mit konischen Abschnitten 66 in entsprechend kleinere Lochabschnitte 67 über.

Bei einer Schräganordnung des Prüfstiftes 14 bzw. 32 (Fig. 10) findet die Spitze 36 ihre Abstützung schon am Lochrand 63 an der Unterseite der untersten Führungsplatte 16, die bei den Ausführungsbeispielen gemäß Fig. 9 und 10 etwa 3 mm dick ist. Der Abstand a der Spitze 36 von der untersten Führungsplatte 16 beträgt etwa 0,8 mm.

Sofern der Prüfstift 14 eine progressive Verjüngung 30 gemäß Fig. 5 aufweist, empfiehlt es sich, die Länge der progressiven Verjüngung 30 gleich oder kleiner zu bemessen als den Abstand k in Fig. 10, um bei einem Anheben der Leiterplatte 2 bei ihrer Prüfung eine gute Führung des Prüfstifts 14 zu gewährleisten.

Es ist auch möglich, anstelle von zylindrischen Führungslöchern an die Form der Prüfstifte angepaßte, insbesondere konische Führungslöcher vorzusehen.

## Patentansprüche

1. Prüfstift (33) für einen Adapter (13) eines Leiterplattenprüfgerätes, zum Verbinden von im Raster befindlichen Prüfkontakten (7) des Leiterplattenprüfgerätes mit in und/oder außer Raster befindlichen Prüfpunkten (3) eines Prüflings wie einer Leiterplatte (2), wobei der Prüfstift (33) zum Verbinden zugehöriger Prüfkontakte (7) und Prüfpunkte (3) in Führungslöchern (45 bis 49; 45.1 bis 49.1) mit unterschiedlichen Schrägstellungen im Adapter (13) einsteckbar ist, und jeweils einen dem betreffenden Prüfpunkt (3) der Leiterplatte (2) zugewandten, spitz zulaufenden Kontaktierabschnitt (a) und einen sich daran anschließenden Führungsabschnitt (b) aufweist, dessen Querschnitt sich zum Kontaktierabschnitt (a) hin verringert, und wobei der Prüfstift (33) an seinem der Spitze (36) abgewandten Ende einen Kopf (35) mit einer kugelförmigen Anlagefläche aufweist,
**dadurch gekennzeichnet,**
daß sich der Führungsabschnitt (b) gegen den Kontaktierabschnitt (a) hin im Querschnitt stufenförmig verringert, und daß der Übergang (41) von Stufe (39) zu Stufe (39) sich zur Spitze (36) hin konisch verjüngt.

2. Prüfstift nach Anspruch 1,
dadurch gekennzeichnet,
daß der Querschnitt des Prüfstifts (33) sich über einen Teil des Führungsabschnitts (b) bzw. der Schaftlänge (l) zur Spitze (36) hin verringert.

3. Prüfstift nach Anspruch 1,
dadurch gekennzeichnet,
daß der Querschnitt des Prüfstifts (32, 33) sich über den gesamten Führungsabschnitt bzw. über die gesamte Schaftlänge (l) zur Spitze (36) hin verringert.

4. Prüfstift nach einem der Ansprüche 1 bis 3,
dadurch gekennzeichnet,
daß die Anzahl der Stufen (39) der Anzahl der Führungsplatten (15 bis 17) oder der Anzahl der Führungsplatten weniger eins entspricht.

5. Prüfstift nach einem der Ansprüche 1 bis 4,
dadurch gekennzeichnet,
daß der Querschnitt des Prüfstifts (33) sich wenigstens nahe der Spitze (36) progressiv verjüngt.

6. Prüfstift nach einem der Ansprüche 1 bis 5,
dadurch gekennzeichnet,
daß die Länge des Kontaktierabschnitts (a) etwa 0,3 bis 1,5 mm, vorzugsweise etwa 0,8 mm, beträgt.

7. Prüfstift nach einem der Ansprüche 1 bis 6,
dadurch gekennzeichnet,
daß der Durchmesser des Prüfstifts (33) im Bereich der untersten Führungsplatte (16) etwa 0,4 mm beträgt.

8. Prüfstift nach einem der Ansprüche 1 bis 7,
**dadurch gekennzeichnet,**
daß der Kopf (35) die Form einer Kugel aufweist.

## Claims

1. A test pin (33) for an adapter (13) of a printed circuit board testing device, for connecting test contacts (7) of the printed circuit board testing device located on the grid with test points (3), located on or off the grid, of a test sample such as a printed circuit board (2), wherein the test pin (33) can be inserted into guide holes (45 to 49; 45.1 to 49.1) having different inclinations in the adapter (13) to connect associated test contacts (7) and test points (3), and has a contact section (a) running to a point and facing the associated test point (3) of the printed circuit board (2) and an adjoining guide section (b) of which the cross-section decreases towards the contact section (a), and wherein the test pin (33) has a head (35) with a spherical contact surface on its end remote from the tip (36),
characterised in that,
the guide section (b) decreases stepwise in cross-section towards the contact section (a) and that the transition (41) from step (39) to step (39) is tapered conically towards the tip (36).

2. A test pin according to claim 1, characterised in that the cross-section of the test pin (33) decreases over part of the guide section (b) or the shaft length (l) towards the tip (36).

3. A test pin according to claim 1, characterised in that the cross-section of the test pin (32, 33) decreases over the entire guide section or over the entire shaft length (l) towards the tip (36).

4. A test pin according to any one of claims 1 to 3, characterised in that the number of steps (39) corresponds to the number of guide plates (15 to 17), or to the number of guide plates less one.

5. A test pin according to any one of claims 1 to 4, characterised in that the cross-section of the test pin (33) tapers progressively at least near the tip (36).

6. A test pin according to any one of claims 1 to 5, characterised in that the length of the contact section (a) is about 0.3 to 1.5 mm, preferably about 0.8 mm.

7. A test pin according to any one of claims 1 to 6, characterised in that the diameter of the test pin (33) is about 0.4 mm in the region of the lowest guide plate (16).

8. A test pin according to any one of claims 1 to 7, characterised in that the head (35) has the shape of a sphere.

## Revendications

1. Touche de contrôle (33) pour un adaptateur (13) d'un appareil de contrôle et d'essai de cartes à circuit imprimé, destinée à connecter des contacts de contrôle (7) de l'appareil de contrôle et d'essai, disposés en réseau, à des points de contrôle (3), disposés en réseau et/ou hors réseau, d'un élément à contrôler ou à essayer tel qu'une carte à circuit imprimé (2), la touche de contrôle (33) pouvant être introduite dans des trous (45 à 49; 45.1 à 49.1) de guidage avec des inclinaisons différentes dans l'adaptateur (13) aux fins de connecter entre eux des contacts de contrôle (7) et des points de contrôle (3) et comportant respectivement une partie de contact (a) qui se termine en pointe et est orientée vers le point de contrôle (3) concerné de la carte à circuit imprimé (2) et une partie de guidage (b) qui se raccorde à la partie de contact (a) et dont la section diminue en direction de celle-ci, la touche de contrôle (33) comportant en outre, à son extrémité éloignée de la pointe (36), une tête (35) avec une portée sphérique, caractérisée par le fait que la section de la partie de guidage (b) décroît par paliers en direction de la partie de contact (a) et par le fait que la transition de palier (39) à palier (39) diminue en formant un cône en direction de la pointe (36).

2. Touche de contrôle selon la revendication 1, caractérisée par le fait que la section de la touche de contrôle (33) décroît en direction de la pointe (36) sur une portion de la partie de guidage (b) ou de la longueur de la tige (1).

3. Touche de contrôle selon la revendication 1, caractérisée par le fait que la section de la touche de contrôle (32, 33) décroît en direction de la pointe (36) sur l'ensemble de la partie de guidage ou de la longueur de la tige (1).

4. Touche de contrôle selon une des revendications 1 à 3, caractérisée par le fait que le nombre de paliers (39) correspond au nombre de plaques de guidage (15 à 17) ou au nombre de plaques de guidage moins une.

5. Touche de contrôle selon une des revendications 1 à 4, caractérisée par le fait que la section de la touche de contrôle (33) décroît progressivement, au moins au voisinage de la pointe (36).

6. Touche de contrôle selon une des revendications 1 à 5, caractérisée par le fait que la longueur de la partie de contact (a) est d'environ 0,3 à 1,5 mm, de préférence de 0,8 mm environ.

7. Touche de contrôle selon une des revendications 1 à 6, caractérisée par le fait que le diamètre de la touche de contrôle (33), dans la région de la plaque de guidage (16) inférieure, est de 0,4 mm environ.

8. Touche de contrôle selon une des revendications 1 à 7, caractérisée par le fait que la tête (35) a la forme d'une sphère.
